# EUROPEAN PATENT SPECIFICATION

(11) **EP 0 597 096 B1**
(45) Date of publication and mention of the grant of the patent: **01.09.1999**
(21) Application number: 92909850.7
(22) Date of filing: 01.05.1992
(51) Int. Cl.: C30B 29/52, C30B 11/00, C22C 1/02

(54) **METHOD FOR PRODUCING MAGNETOSTRICTIVE MATERIAL**
VERFAHREN ZUR HERSTELLUNG VON MAGNETOSTRIKTIVEM MATERIAL
PROCEDE PERMETTANT DE PRODUIRE UN MATERIAU MAGNETOSTRICTIF

(43) Date of publication of application: 18.05.1994
(73) Proprietor: TDK Corporation, Chuo-ku, Tokyo-to 103 (JP)
(72) Inventor: MORI, Teruo, Chuo-ku, Tokyo 103 (JP); OKAMOTO, Shigeo, Chuo-ku, Tokyo 103 (JP); HIROSE, Kazunori, Chuo-ku, Tokyo 103 (JP)
(74) Representative: Vogeser, Werner, Dipl.-Ing.
(86) International application number: JP9200574
(87) International publication number: WO9322467

(56) References cited:
- EP-A- 0 282 059
- JP-A- 50 060 797
- JP-B- 59 021 935

## Description

### Field of the Invention

This invention relates to a method for manufacturing magnetostrictive materials such as RTM₂ wherein R is a rare earth element inclusive of Y and TM is a transition element.

### Prior art

For the manufacture of monocrystalline or prismatic crystal alloys by unidirectional solidification, a zone melting process is well known as disclosed in US Patent No. 4,609,402. The zone melting process involves inserting a raw alloy ingot in the form of a rod of a rare earth metal-iron alloy into a mold, placing a heater outside the mold at the bottom so as to enclose the mold, conducting electric current across the heater, thereby melting the raw alloy, and gradually lifting the heater upward relative to the mold.

In the zone melting process, the lowermost portion of the raw alloy is melted upon current conduction across the heater. As the heater is gradually lifted upward or moved apart from the molten zone, the temperature of the molten zone lowers. Since the lifting rate of the heater is selected such that the molten zone may have a predetermined temperature gradient, the source alloy is unidirectionally solidified gradually from the bottom up, thus producing a monocrystalline or prismatic crystal alloy.

### DISCLOSURE OF THE INVENTION

The raw alloy ingot used in the zone melting process is generally prepared by a low-pressure casting process. The low-pressure casting process has a propensity for compositional deviation due to the increased evaporation of rare earth elements and segregation due to the difficulty of uniform heating and cooling. In addition, the raw alloy ingot must be processed to a desired shape by machining or the like, with a concomitant loss of material.

Further, the zone melting process is impossible to continuously produce a monocrystalline or prismatic crystal body which is longer than the starting alloy ingot.

Further, when a monocrystalline or prismatic crystal alloy is cast through unidirectional solidification in accordance with the zone melting process, part of the heat generated by the heater transfers upward through the raw alloy and eventually dissipates in vain, indicating the problem that part of the heat or power supply is consumed wastefully.

Further, since the conventional zone melting process should taken into account not only the heat which is transferred downward from the heater as required for the manufacture of a monocrystalline or prismatic crystal alloy, but also the amount of heat which is transferred upward through the raw alloy, there arises a problem of complexity to adjust the heat amount and hence, the current supply.

Further, when the raw alloy is melted by means of the heater to form a molten metal zone in accordance with the conventional zone melting process, a portion of the raw alloy located above the molten metal zone can go down into the molten metal zone as a mass for some reason or other, resulting in that molten metal zone experiencing a sudden temperature drop. The temperature control intended to provide a predetermined temperature gradient becomes very complicated in this case. The temperature control is more difficult in that it is unexpectable when the raw alloy goes down into the molten metal zone as a mass.

Exact control of the cooling rate is essential to grow a crystal of quality. For example, if the cooling rate of a molten metal zone is too fast, a significant difference in cooling rate can occur between the surface and the interior of the material, resulting in a disordered crystal array. Therefore, the conventional zone melting process is altered by modifying the coil for high-frequency induction heating so as to include closely and sparsely wound regions whereby a molten metal zone is formed in the closely wound region and the time taken until solidification is controlled in the sparsely wound region. The optimum cooling rate, however, largely depends on the material composition. The cooling rate also depends on conditions of various components of the apparatus, for example, heat transfer coefficient. Essential considerations of these various conditions render the monocrystal manufacturing apparatus less versatile. For example, since the above-mentioned coil including closely and sparsely wound regions must be of special design for a specific crystal composition, a change of any condition such as raw material composition requires replacement of the heating unit itself, indicating that the apparatus is not suitable for cost effective mass production.

In connection with the manufacture of a monocrystalline magnetostrictive material containing R and TM and having a dendrite structure, objects of the present invention are to eliminate a limit on the length of a rod that can be continuously manufactured, to minimize a loss of material, to reduce wasteful power consumption, to facilitate adjustment of current supply to the heater, and to manufacture a crystal body of quality having a non-disordered crystal array and a greater amount of magnetostriction at low cost.

These and other objects are achieved by the present invention which is defined from (1) to (7) below.
1. A method for manufacturing a magnetostrictive material containing R and TM wherein R is a rare earth element inclusive of Y and TM is a transition element,
   said method comprising the steps of continuously feeding a source material in powder form having a particle size of 100 µm to 1 mm, melting said source material after the continuous feed step, the source material in powder form being fed into the previously fed, molten source material, and allowing the continuously fed molten source material to gradually solidify.
2. The magnetostrictive material manufacturing method of (1) wherein said magnetostrictive material has a dendrite structure resulting from unidirectional solidification.
3. The magnetostrictive material manufacturing method of (1) or (2) wherein said source material is an alloy containing R and TM, which is subject to hydrogen occlusion, hydrogen depletion, and annealing before it is continuously fed.
4. The magnetostrictive material manufacturing method of any one of (1)-(3) which is to manufacture a magnetostrictive material having a composition of the formula: R(Fe_{1-y}T_{y})ₓ wherein x and y represent atomic ratios, y = 0 to 0.4, x = 1 to 3, and T is at least one transition element other than Fe.
5. The magnetostrictive material manufacturing method of any one of (1)-(4) wherein said continuous feed step is to continuously feed a unit amount per unit time of the source material held at a temperature in a predetermined range.
6. The magnetostrictive material manufacturing method of any one of (1)-(5) wherein said continuous feed step, said melting step and said solidification step are conducted in an argon gas atmosphere.
7. The magnetostrictive material manufacturing method of any one of (1)-(6) wherein the melting is by high-frequency induction heating.

### OPERATION AND ADVANTAGES OF THE INVENTION

In accordance with the present invention, a monocrystalline body is manufactured by continuously feeding a source material into a mold and causing the molten source material to gradually solidify in the mold. In principle, no limit is imposed on the length of a crystal body which can be continuously manufactured and the crystal body can be manufactured to any desired length. Since the source material is an alloy having the same composition as the magnetostrictive material to be produced or a mixture of metal elements constituting the magnetostrictive material and is directly melted and solidified, evaporation of rare earth elements is minimized and the percent utility of the source material is high.

In manufacturing a monocrystalline alloy through unidirectional solidification in accordance with the present invention, no heat is dissipated upward beyond the heater in principle. This eliminates wasteful power consumption and facilitates the adjustment of power consumption.

Further, the present invention enables to control the cooling rate by simple means of providing a heat insulating member and a movable heat insulating member as defined above, ensuring cost effective manufacture of a crystal body of quality whose crystal array is little disordered. There is obtained a magnetostrictive material having a greater amount of magnetostriction. Since the movable heat insulating member is prone to detachable design, the apparatus can accommodate for the manufacture of crystal bodies of different compositions.

### BRIEF DESCRIPTION OF THE DRAWINGS

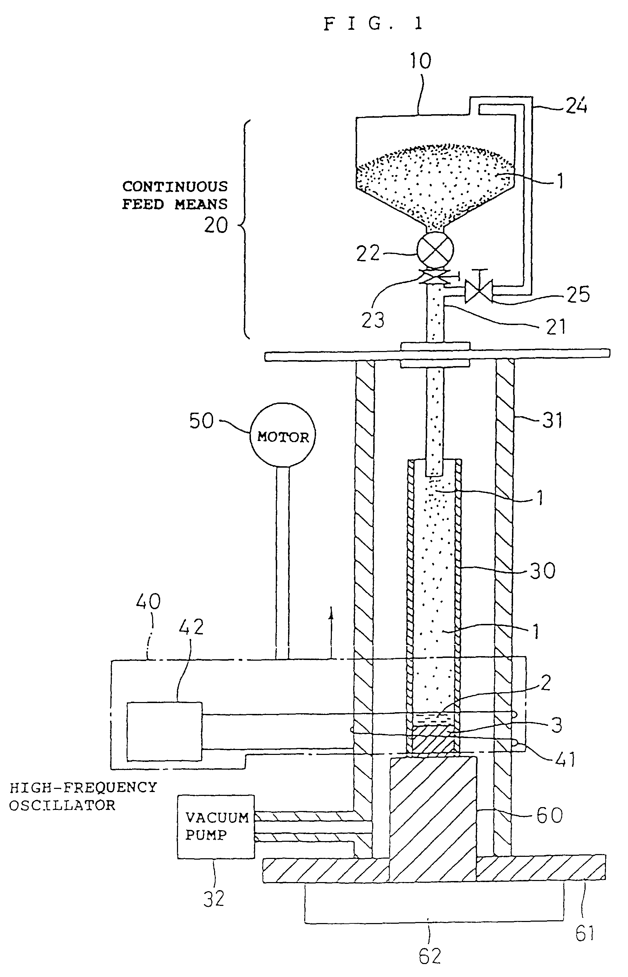

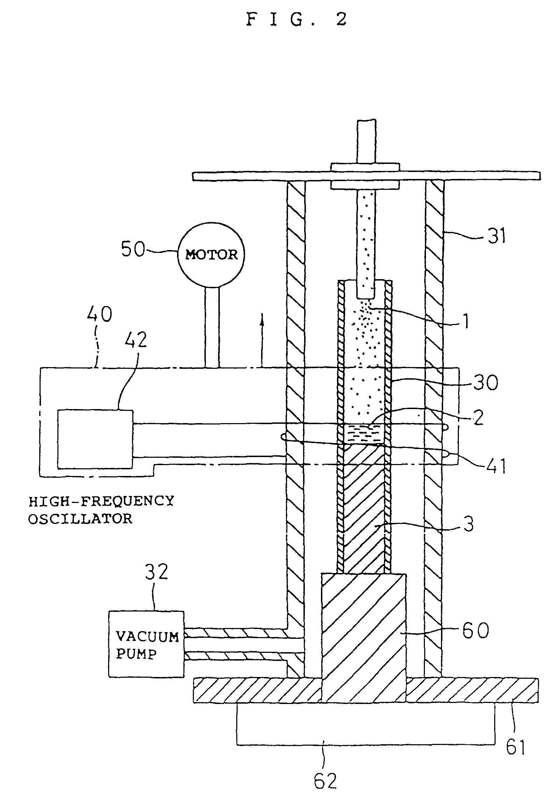

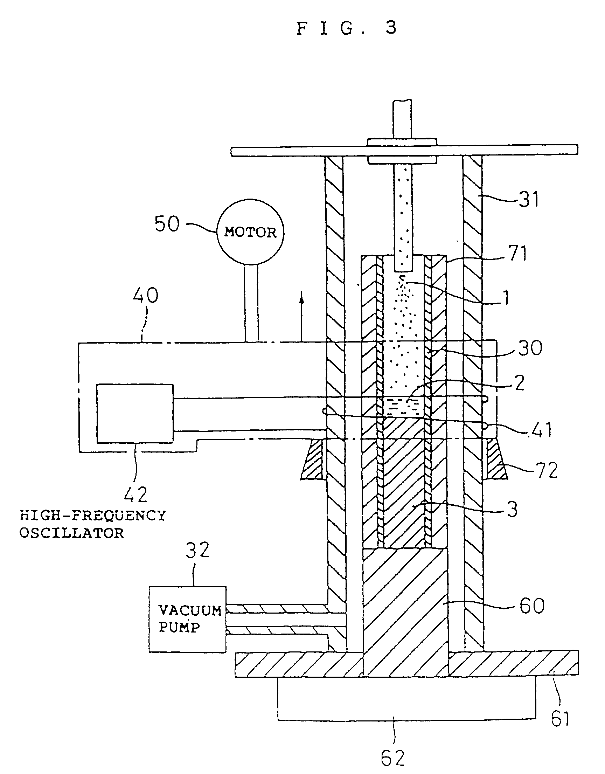

FIG. 1 illustrates one embodiment of the present invention. FIG. 2 illustrates the one embodiment at an intermediate stage of a magnetostrictive material manufacturing process. FIG. 3 illustrates another embodiment of the present invention.

### BEST MODE FOR CARRYING OUT THE INVENTION

FIG. 1 illustrates one embodiment of the present invention. The manufacturing apparatus of the illustrated embodiment includes a hopper 10 for receiving a source material 1, a feed pipe 21 defining a path for feeding the source material 1 from the hopper 10 to a mold 30, and a rotary valve 22 disposed in the feed pipe 21. Understandably, the rotary valve 22 rotates at a constant rate to continuously feed the source material 1 into the mold 30. A unit amount per unit time of the source material 1 is continuously fed into the mold 30. Therefore, the hopper 10, feed pipe 21 and rotary valve 22 form continuous feed means 20 for continuously feeding a unit amount per unit time of the source material into the mold.

Disposed in the feed pipe 21 is a ball valve 23 which is closed when it is desired to establish a high vacuum in the atmosphere covering from the hopper 10 to the mold 30. It is to be noted that a pressure equalizing tube 24 is connected to both the feed pipe 21 and the hopper 10 and provided midway with a valve 25.

A housing 31 encloses the feed pipe 21, mold 30 and a water cooled block 60. The interior of the housing 31 may be evacuated to a vacuum of about 1.3 to 1.3 x 10⁻³ Pa (10⁻² to 10⁻⁵ Torr) by means of a vacuum pump 32.

A heater 40 includes a coil 41 wrapped around the housing 31 and a high-frequency oscillator 42 for supplying high-frequency current to the coil 41.

A motor 50 is coupled to the heater 40 so as to move the heater upward at a predetermined rate. This motor is one example of lift means for moving the heater 40 upward relative to the mold 30.

The water cooled block 60 is in contact with the bottom of the mold 30 for cooling the source material 1 which has been melted by means of the heater 40. Base plates 61 and 62 are disposed at the bottom of the water cooled block 60. It will be understood that the water cooled block 60 is one example of heat sink means for allowing the molten source material to dissipate heat.

More particularly, the source material 1 which is used in the above-illustrated embodiment is not particularly limited as long as it contains R and TM wherein R is a rare earth element inclusive of Y and TM is a transition element. For use as magnetostrictive material, the source material should preferably have a composition of the following formula.

R(Fe_{1-y}T_{y})ₓ

In the formula, x and y represent atomic ratios, y = 0 to 0.4, x = 1 to 3, and T is at least one transition element other than Fe. Preferably, R is at least one member selected from the group consisting of Y, Ce, Pr, Nd, Sm, Gd, Tb, Dy, Ho, Er and Yb. Essential inclusion of at least one of Tb and Ho is preferred in order to form a dendrite structure to be described later, with essential inclusion of Tb being especially preferred.

Also preferably, T is at least one member selected from the group consisting of Co, Ni, Mn, Cr, Mo, W, Zn, Rh, Nb and Cu.

Next, the operation of the above-illustrated embodiment is described.

First, the source material 1 is admitted into the hopper 10. The source material 1 used herein is often an alloy powder or a mix powder of metal elements. The alloy may be selected from the above-defined magnetostrictive material composition while the metal elements may be selected from the elements of which the magnetostrictive material is formed.

After admission of the source material, the ball valve 23 is closed, the valve 25 is opened, and the vacuum pump 32 is then operated until a high vacuum is established within the housing 31. Thereafter, the interior of the housing 31 is purged with argon or an argon gas stream is passed therethrough, and the ball valve 23 is opened. Understandably, the housing 31 interior may be kept in a high vacuum.

Now, the rotary valve 22 is rotated at a constant rate for continuously feeding the source material 1. The feed rate of the source material may be properly determined in accordance with the size of the apparatus, for example, in the range of about 10 to 60 g/h.

More particularly, with the coil 41 located at the lowest position of the mold 30 which is previously charged with the source material 1 having a sufficiently large particle size to induce eddy current, the high-frequency oscillator 42 is operated to conduct high-frequency current across the coil 41. Then eddy current flows through the source material 1 deposited on the bottom of the mold 30 so that the source material 1 is melted within a short period of time. Now that the source material 1 deposited on the mold 30 bottom has formed a molten metal zone 2, the continuous feed of the source material is started. The use of high-frequency induction heating as in the illustrated embodiment facilitates temperature control.

Thereafter, the motor 50 operates to gradually lift the heater 40 and the coil 41 therewith so that the coil 41 is gradually moved apart from the mold 30 bottom. At this point, the temperature of the molten metal in the vicinity of the mold 30 bottom lowers slowly due to heat release to the water cooled block 60. The lifting rate of the coil 41 (or the lifting rate of the heater 40) is selected such that the molten metal may unidirectionally solidify into a desired crystal, that is, so as to provide an adequate temperature gradient.

As the heater 40 is lifted a predetermined distance after the lapse of a predetermined time, the zone which has been a molten metal zone converts into a solidified zone 3. In this way, a monocrystalline alloy is produced through unidirectional solidification from the mold 30 bottom up. As the process is continued, the solidified zone 3 is gradually increased in height.

When the source material 1 in powder form drops in and mixes with the molten metal zone 2, the source material 1 is quickly converted into a molten metal because of particles' very small volume. Since the increment of the source material 1 which is subsequently mixed is very small as compared with the entire volume of the molten metal in the molten zone 2, the molten zone 2 maintains a substantially constant temperature. It is to be noted that when high-frequency induction heating means as illustrated in the figures is used as the heater 40, the arrangement in which the source material powder is melted in the region enclosed by the coil before entry into the molten metal zone 2 is acceptable.

Therefore the source material is of a size of 100 µm to 1 mm. The frequency of the high-frequency current through the coil 41 may be properly determined in accordance with the size of particles comprising the source material powder and often selected in the range between about 10 kHz and about 3 MHz although the frequency is not limited thereto. The smaller the source material particles, the higher should be the current frequency.

In the case of high-frequency induction heating, the coil is preferably provided with a cooling water path for suppressing excess temperature increase of the coil itself. In general, water cooling can maintain the coil at a temperature of about 60°C or lower.

With the valve 25 kept open during the above-mentioned process, the equalizing pipe 24 functions to equalize the pressures in the pipe 21 and the hopper 10.

In the process of gradually lifting the heater 40 relative to the mold 30 in the above-mentioned manner, when the coil 41 reaches an intermediate position of the mold 30 as shown in FIG. 2, the heat generated by the heater 40 is partially absorbed by the source material 1 which is now fed from the hopper 10 and mixed into the molten metal zone 2 and the remaining heat is transferred to the water cooled block 60 through the solidified zone 3. No power is wastefully consumed at this point because the surface of the molten metal zone 2 is in contact with argon so that little heat may escape from the molten metal zone 2 to the argon.

The fact that little heat transfers from the molten metal zone 2 to the argon also facilitates the adjustment of current supply to the heater 40. Differently stated, insofar as a constant current is supplied to the coil 41, the temperature within the coil 41 remains unchanged wherever the coil 41 is located during the above-mentioned control process. This ensures to always maintain the molten metal zone 2 at a constant temperature insofar as the high-frequency oscillator 42 supplies a constant current. Since the current control (or temperature control) is easy as mentioned above, the magnetostrictive material is produced in high yields.

Although the mold 30 is of a uniform cross section in the above-illustrated embodiment, a mold whose cross section varies with height, that is, a non-columnar mold may be used instead of the mold 30. Since the source material 1 is heated and melted by virtue of eddy current, the amount of heat required for a varying cross-sectional area is automatically controlled.

In most cases, the source material 1 is subject to hydrogen occlusion, hydrogen depletion and annealing and then comminuted into a powder before it is admitted into the hopper 10. The source material 1 as annealed may be disintegrated and size classified before it is continuously fed into the mold 30. It is also possible to carry out annealing before hydrogen occlusion and, if desired, to carry out additional annealing after the hydrogen occlusion. Further, instead of the procedure including hydrogen occlusion, hydrogen depletion, annealing, disintegration, and size classification, a conventional pulverizing step may be used.

In the embodiment, it is also possible to maintain the source material 1 in the hopper 10 at a temperature within a predetermined range by temperature maintaining means (not shown). The reason why the source material 1 is maintained at a predetermined temperature is to ensure that the molten metal zone 2 reaches a constant temperature as fast as possible after a constant current is supplied to the heater 40. The temperature may be room temperature or any higher or lower temperature insofar as it is maintained constant.

The present invention enables continuous manufacture of a monocrystalline magnetostrictive material without a limit on its length. For example, it is possible to continuously produce a crystal body without changing solidifying conditions, by arranging such that the solidified crystal body is taken out of the apparatus at the bottom as the source material is fed into the hopper. In this case, usually the coil is fixed and the source material fed is moved down. That is, with the coil fixed, the solidification zone is shifted downward. Also in this case, the apparatus is maintained gas tight during supply of the source material into the apparatus and removal of the crystal body from the apparatus, by providing an argon gas purging chamber.

Although a coil for high-frequency induction heating is used as the heater 40 in the illustrated embodiment, another heating means, for example, a resistance heating coil may be used. Any other heating means such as infrared convergent heating may also be used.

Another embodiment of the present invention is described. The other embodiment of the invention is illustrated in FIG. 3.

The manufacturing apparatus shown in FIG. 3 includes a heat insulating member 71 disposed between a mold 30 and a housing 31 as in the apparatus of FIG. 1, the member 71 enclosing the mold 30. The heater 40 is provided with a movable heat insulating member 72 which extends downward beyond the heater 40 and encircles the mold 30. The movable heat insulating member 72 is designed to encircle the solidification zone 3 nearly from the bottom of the molten metal zone 2 and adapted to move with the heater 40. Although the movable heat insulating member 72 is provided only on the lower side of the coil 41 in the illustrated embodiment, the movable heat insulating member 72 may partially cover the coil 41 from the outside or partially intervene between the coil 41 and the housing 31.

The heat insulating member 71 is effective for preventing convection for maintaining a stable temperature distribution in the housing 31. The stationary and movable heat insulating members 71 and 72 also function to control the cooling rate of the molten metal for improving the energy efficiency of the apparatus. These heat insulating members are effective for restraining rapid cooling of the molten metal, especially heat release from the mold 30 side wall, thereby preventing any significant difference in cooling rate from occurring between the surface and the interior of the source material within the mold, thus preventing crystal array disordering. The heat insulating members are also effective for controlling the solid phase reaction that takes place in the solidification zone 3 in the vicinity of the molten metal zone 2.

Since the optimum cooling rate to produce a homogeneous monocrystal varies with the composition of source material used, the material, shape, dimensions and the like of the stationary and movable heat insulating members 71 and 72 may be properly determined in accordance with the source material composition and are not particularly limited. It will be understood that a slower cooling rate can be established by using the movable heat insulating member 72 which gradually increases its thickness with a larger distance from the coil 41 as in the illustrated embodiment.

If the movable heat insulating member 72 is of detachable design, the present apparatus is applicable to the manufacture of monocrystal bodies of different compositions because the cooling rate of the molten metal zone 2 can be altered simply by exchanging the movable heat insulating member 72. As opposed to the prior art monocrystal manufacturing apparatus which are impossible to alter the cooling rate in a substantial sense, the present apparatus can manufacture high-quality monocrystal bodies of different compositions at low cost because the movable heat insulating member 72 is inexpensive to prepare and easy to design for detachment. It is to be noted that means for securing the movable heat insulating member 72 to the coil 41 is not particularly limited and such a member may be secured by adhesive bond, bolt connection or the like.

The material of which the stationary and movable heat insulating members 71 and 72 are formed is not particularly limited although alumina, zirconia, magnesia, calcia and so forth are generally preferred, with alumina being especially preferred for cost reduction.

It is to be noted that the surfaces of the stationary and movable heat insulating members 71 and 72 that face the mold 30 are preferably finished as a mirror surface because better heat insulation is accomplished. Similar results are obtained by using a mirror finished metal plate as the movable heat insulating member 72.

The materials of which the remaining members are formed are not particularly limited and may be suitably selected in accordance with the conventional monocrystal manufacturing apparatus. For example, in the case of high-frequency induction heating, the housing 31 may be formed of a material having a low electroconductivity such as transparent quartz glass, Pyrex glass, and soft glass, with the quartz glass being preferred because of its low coefficient of thermal expansion. The mold 30 is formed of a material which is immune to the molten source material, such as quartz glass, BN, alumina, calcia, and magnesia.

It is to be noted that either one of the stationary and movable heat insulating members 71 and 72 may be provided for achieving satisfactory results although both the members are provided for better results.

In this way, there is manufactured a rod of magnetostrictive material which is a crystal body having a dendrite structure resulting from unidirectional solidification. This structure is disclosed in Metallurgical Transactions, A 223-231, 18A, 1987. The crystal body is a laminate body in the form of a parallel array including dendrite sheets of a RTM₂ compound grown in <112> direction and having a surface in {111} plane and having a thickness of about 0.5 to 1.5 mm and polycrystalline or monocrystalline sheets of a R-rich peritectic compound having a thickness of submicrons to several microns. Although this is not a monocrystal in an exact sense due to the presence of parallel twin planes, it is generally referred to as a monocrystal. Due to this structure, the material provides a greater amount of magnetostriction. The present invention is especially suited for the manufacture of magnetostrictive material with such a structure.

### EXAMPLE

Examples of the present invention are given below by way of illustration.

Magnetostrictive materials were manufactured using the apparatus shown in FIG. 1, the apparatus shown in FIG. 3 with the movable heat insulating member 72 omitted, and the apparatus shown in FIG. 3. Table 1 shows whether or not the stationary and movable heat insulating members 71 and 72 were used.

The source materials used were powders (#32 to #100) of Tb-Dy-Fe alloys. The source material compositions are shown in Table 1. Respective components of the apparatus had the following dimensions.
- Coil 41:: height 40 mm (4 turns)
- Mold 30:: quartz glass made (cylindrical)
inner diameter 13 mm
thickness 1 mm
height 300 mm
- Housing 31:: quartz glass made (cylindrical)
inner diameter 26 mm
thickness 2 mm
height 500 mm
- Heat insulating member 71:: alumina made (cylindrical)
inner diameter 16 mm
thickness 2 mm
height 300 mm
- Movable heat insulating member 72:: alumina made (cylindrical)
inner diameter 32 mm
thickness 4 mm
height 50 mm

Table 1 shows the moving rate at which the coil 41 and the movable heat insulating member 72 were lifted upward.

Table 1 shows amounts of magnetostriction of the thus manufactured magnetostrictive materials. The amount of magnetostriction was measured in an external magnetic field having an intensity of 0.4 kOe and 1 kOe.

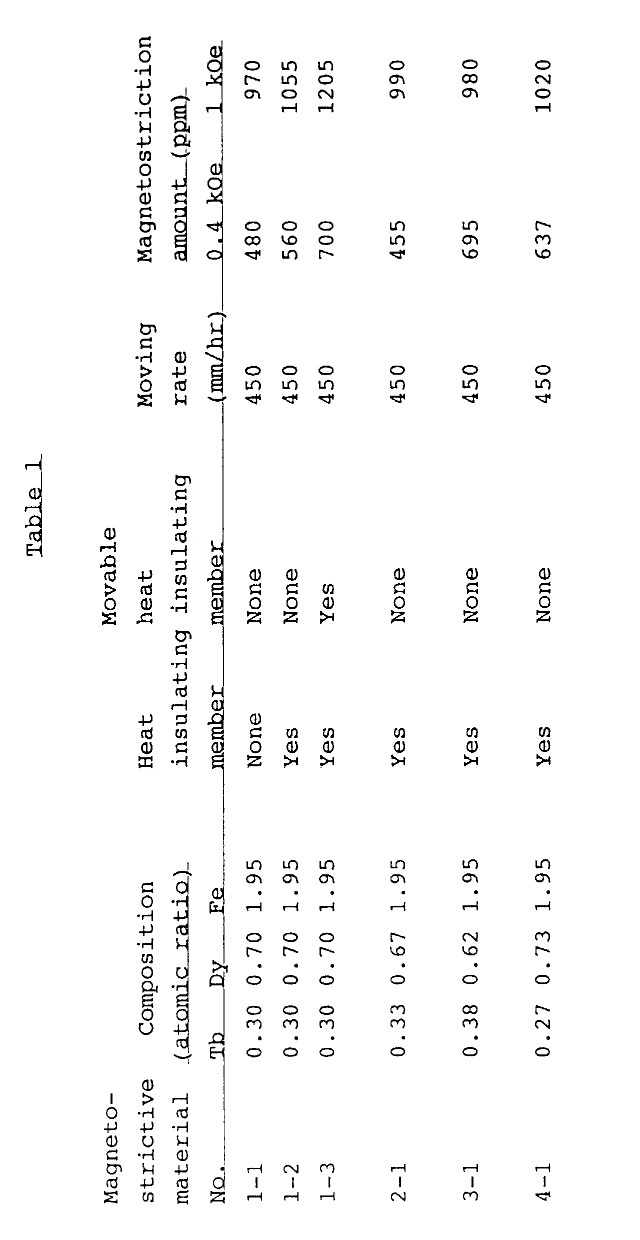

The effectiveness of the present invention is evident from the results of Table 1.

## Claims

1. A method for manufacturing a magnetostrictive material containing R and TM wherein R is a rare earth element inclusive of Y and TM is a transition element,
said method comprising the steps of continuously feeding a source material in powder form having a particle size of 100 µm to 1 mm, melting said source material after the continuous feed step, the source material in powder form being fed into the previously fed, molten source material and allowing the continuously fed molten source material to gradually solidify.

2. The magnetostrictive material manufacturing method of claim 1 wherein said magnetostrictive material has a dendrite structure resulting from unidirectional solidification.

3. The magnetostricitive material manufacturing method of claim 1 or 2 wherein said source material is an alloy containing R and TM, which is subject to hydrogen occlusion, hydrogen depletion, and annealing before it is continuously fed.

4. The magnetostricitive material manufacturing method of any one of claims 1 to 3 which is to manufacture a magnetostricitive material having a composition of the formula: R(Fe_{1-y}T_{y})ₓ wherein x and y represent atomic ratios, y = 0 to 0.4, x = 1 to 3, and T is at least one transition element other than Fe.

5. The magnetostricitive material manufacturing method of any one of claims 1 to 4 wherein said continuous feed step is to continuously feed a unit amount per unit time of the source material held at a temperature in a predetermined range.

6. The magnetostricitive material manufacturing method of any one of claims 1 to 5 wherein said continuous feed step, said melting step and said solidification step are conducted in an argon gas atmosphere.

7. The magnetostricitive material manufacturing method of any one of claims 1 to 6 wherein the melting is by high-frequency induction heating.

## Patentansprüche

1. Verfahren zur Herstellung eines R und TM enthaltenden magnetostriktiven Materials, worin R ein seltenes Erdmetallelement einschließlich Y und TM ein Übergangselement ist,
wobei das Verfahren die Schritte des kontinuierlichen Zuführens eines Quellenmaterials in Pulverform mit einer Teilchengröße von 100µm bis 1mm, Schmelzen dieses Quellenmaterials nach dem kontinuierlichen Zuführschritt, wobei das Quellenmaterial in Pulverform in das vorher zugeführte, geschmolzene Quellenmaterial zugeführt wird, und Zulassen des graduellen Verfestigens des kontinuierlich zugeführten geschmolzenen Quellenmatierals umfaßt.

2. Verfahren zur Herstellung eines magnetostriktiven Materials nach Anspruch 1, worin das magnetostriktive Material eine aus der unidirektionellen Verfestigung resultierende Dendritstruktur hat.

3. Verfahren zur Herstellung eines magnetostriktiven Materials nach Anspruch 1 oder 2, worin das Quellenmaterial eine R und TM enthaltende Legierung ist, welches einer Wasserstoffeinschließung, Wasserstoffverarmung und Vergütung unterworfen wird, bevor es kontinuierlich zugeführt wird.

4. Verfahren zur Herstellung eines magnetostriktiven Materials nach einem der Ansprüche 1 bis 3, um ein magnetostriktives Material mit einer Zusammensetzung der Formel R(Fe_{1-y}T_{y})ₓ herzustellen, worin x und y Atom-Verhältnisse darstellen, y = 0 bis 0,4, x = 1 bis 3 und T zumindest ein anderes Übergangselement als Fe ist.

5. Verfahren zur Herstellung eines magnetostriktiven Materials nach einem der Ansprüche 1 bis 4, worin der kontinuierliche Zuführschritt ein kontinuierliches Zuführen einer Einheitsmenge pro Einheitszeit des Quellenmaterials ist, das bei einer Temperatur in einem vorher bestimmten Bereich gehalten wird.

6. Verfahren zur Herstellung eines magnetostriktiven Materials nach einem der Ansprüche 1 bis 5, worin der kontinuierliche Zuführschritt, der Schmelzschritt und der Verfestigungsschritt in einer Argongas-Atmosphäre durchgeführt werden.

7. Verfahren zur Herstellung eines magnetostriktiven Materials nach einem der Ansprüche 1 bis 6, worin das Schmelzen ein Hochfrequenzinduktionserwärmen ist.

## Revendications

1. Procédé de fabrication d'un matériau magnétostrictif contenant R et TM dans lequel R est un élément de terre rare, incluant Y, et TM est un élément de transition, ledit procédé comprenant les étapes consistant à introduire en continu un matériau source sous forme de poudre ayant une granulométrie de 100 pm à 1 mm, fondre ledit matériau source après l'étape d'introduction en continu, le matériau source sous forme de poudre étant introduit dans le matériau source fondu introduit préalablement, et laisser le matériau source fondu introduit en continu se solidifier graduellement.

2. Procédé de fabrication d'un matériau magnétostrictif selon la revendication 1, caractérisé en ce que ledit matériau magnétostrictif a une structure dendritique résultant de la solidification unidirectionnelle.

3. Procédé de fabrication d'un matériau magnétostrictif selon la revendication 1 ou 2, caractérisé en ce que ledit matériau source est un alliage contenant R et TM, qui est soumis à une inclusion d'hydrogène, un épuisement d'hydrogène, et un recuit avant d'être introduit en continu.

4. Procédé de fabrication d'un matériau magnétostrictif selon l'une quelconque des revendications 1 à 3, qui est de fabriquer un matériau magnétostrictif ayant une composition de formule : R(Fe_{1-y}T_{y})ₓ dans laquelle x et y représentent des rapport atomiques, y = 0 à 0,4, x = 1 à 3, et T est au moins un élément de transition autre que Fe.

5. Procédé de fabrication d'un matériau magnétostrictif selon l'une quelconque des revendications 1 à 4, caractérisé en ce que ladite étape d'introduction en continu est d'introduire en continu une quantité unitaire par unité de temps du matériau source maintenu à une température dans une plage prédéterminée.

6. Procédé de fabrication d'un matériau magnétostrictif selon l'une quelconque des revendications 1 à 5, caractérisé en ce que ladite étape d'introduction en continu, ladite étape de fusion et ladite étape de solidification sont effectuées dans une atmosphère d'argon gazeux.

7. Procédé de fabrication d'un matériau magnétostrictif selon l'une quelconque des revendications 1 à 6, caractérisé en ce que la fusion est effectuée par chauffage par induction à haute fréquence.
